# EUROPEAN PATENT APPLICATION

(11) **EP 1 180 689 A2**
(43) Date of publication of application: **20.02.2002**
(21) Application number: 01306815.0
(22) Date of filing: 09.08.2001
(51) Int. Cl.: G01R 23/15

(54) **Frequency determination circuit for a data processing unit**

(30) Priority: 14.08.2000 JP 2000245837
(71) Applicant: NEC CORPORATION, Tokyo (JP)
(72) Inventor: Saito, Hirofumi, Nec Ic Microcomputer Systems, Ltd, Kawasaki-shi, Kanagawa (JP)
(74) Representative: Moir, Michael Christopher

(57) **Abstract**

A frequency determination circuit (204) determines, with a high precision, whether the frequency of a clock signal (CLK) is higher or lower than a reference frequency. A capacitor element (251) is charged/discharged with a power supply voltage (VDD) that is cycled by a switching transistor according to the clock signal. A comparator circuit (215) compares a constant reference voltage produced by a band-gap regulator (211) circuit from the power supply voltage with a voltage stored in the capacitor element. A high/low determination circuit (216) determines, from the output signal of the comparator circuit, whether the clock signal frequency is higher or lower than a predetermined reference frequency. This makes it possible to determine with precision whether the clock signal has a low frequency or a high frequency.

## Description

### BACKGROUND OF THE INVENTION

### 1. Field of the Invention

The present invention relates to a frequency determination circuit that determines whether a clock signal frequency is higher or lower than a predetermined reference frequency, and to a data processing unit for restricting the operation of a data processing circuit according to the result of the frequency determination circuit.

### 2. Description of the Related Art

Currently, various types of data processing units are used in various types of applications, and such data processing units perform various types of data processing operations with a data processing circuit provided therein. Typically, the data processing unit performs data processing operations according to a clock signal. A processing malfunction, or a similar error, may occur when the clock signal frequency deviates from an acceptable range.

In view of this problem, some data processing units have a frequency determination circuit for stopping the data processing circuit before the clock signal frequency deviates from an acceptable range. The frequency determination circuit determines whether the clock signal frequency is higher or lower than a predetermined reference frequency.

For example, such a frequency determination circuit is disclosed in Japanese Laid-Open Patent Publication Heisei 10-288635 and Japanese Laid-Open Patent Publication Heisei 11-134605. The frequency determination circuit described in Japanese Laid-Open Patent Publication Heisei 10-288635 will now be described with reference to FIG. 1 and FIGS. 2A to 2C.

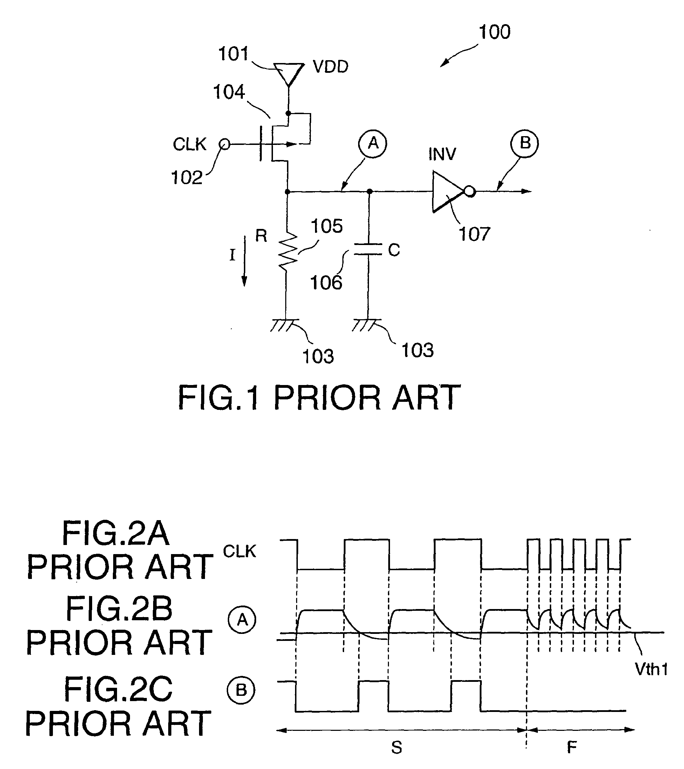

Referring to FIG. 1, the frequency determination circuit 100 comprises a power supply terminal 101 to which a power supply voltage is externally input, a clock terminal 102 to which a clock signal is externally input, and a ground terminal 103 which is kept at a ground potential. The frequency determination circuit 100 also comprises a switching transistor 104.

More specifically, the clock terminal 102 is connected to the gate electrode of the switching transistor 104, and the power supply terminal 101 is connected to the source electrode thereof. A resistance element 105, a capacitor element 106 and an inverter gate 107 are connected to the drain electrode of the switching transistor 104. The other end of the resistance element 105 and the other end of the capacitor element 106 are connected to the ground terminal 103.

The resistance element 105 and the capacitor element 106 together form a delay circuit. The capacitor element 106 continuously charges and discharges with the power supply voltage according to a predetermined time constant. Based on a predetermined threshold voltage Vth1, the inverter gate 107 generates a binary output for switching, based on whether the input voltage is higher or lower than the threshold voltage Vth1.

The frequency determination circuit 100 determines whether the frequency of an externally input clock signal is higher or lower than a predetermined reference frequency. More specifically, the capacitor element 106 is charged with the power supply voltage when the switching transistor 104 is turned ON by the clock signal and is discharged when it is turned OFF.

Since the potential stored in the capacitor element 106 is the input voltage to the inverter gate 107, the binary output is switched based on whether the potential stored in the capacitor element 106 is higher or lower than the threshold voltage Vth1 of the inverter gate 107. As illustrated in FIGS. 2A to 2C, if the clock signal frequency is lower than the predetermined reference frequency, the potential stored in the capacitor element 106 passes through the threshold voltage of the inverter gate 107. If the clock signal frequency is higher than the predetermined reference frequency, the potential stored in the capacitor element 106 is kept higher than the threshold voltage of the inverter gate 107.

Therefore, the binary output of the inverter gate 107 is periodically switched if the clock signal frequency is lower than the predetermined reference frequency. In addition, the output stabilizes (i.e., non-transitioning) if the clock signal frequency is higher than the reference frequency. Thus, it is possible to determine whether the clock signal frequency is lower or higher than the predetermined reference frequency by monitoring the binary output of the frequency determination circuit 100 with a predetermined circuit (not shown).

The frequency determination circuit 100 described above compares the potential stored in the capacitor element 106, which continuously charges and discharges according to a predetermined time constant in synchronism with the clock signal, with the threshold voltage of the inverter gate 107. Thus, it is possible to determine if the clock signal frequency is lower or higher than the reference frequency.

However, the power supply voltage can vary in the frequency determination circuit 100. Such variations of the power supply voltage cause the threshold voltage of the inverter gate 107 to vary as well, thereby reducing the precision of the determination whether the clock signal has a low frequency or a high frequency.

Moreover, variations in the ambient temperature can also cause the threshold voltage of the inverter gate 107 of the frequency determination circuit 100 to vary, thereby reducing the determination precision. Variations of the time constant due to manufacturing errors of the resistance element 104 and the capacitor element 106 also reduce the determination precision.

The preferred embodiment of the present invention has been made in view of the problems as described above, and provides at least one frequency determination circuit in which the clock signal determination precision is not reduced even when the power supply voltage and/or the ambient temperature vary. The present invention further provides a data processing unit for restricting the operation of a data processing circuit according to the determination result of the frequency determination circuit.

### SUMMARY OF THE INVENTION

In one embodiment of the present invention, a frequency determination circuit comprises a band gap regulator circuit, a capacitor element, a switching transistor, a comparator circuit and a high/low determination circuit. A power supply voltage and a clock signal are input thereto.

In one embodiment of the frequency determination circuit of the present invention, the power supply voltage supplied to the capacitor element is turned ON/OFF by the switching transistor according to the clock signal. The capacitor element is charged with the power supply voltage and discharged according to the clock signal. The band gap regulator circuit produces a constant reference voltage from a power supply voltage, and the comparator circuit compares the reference voltage of the band gap regulator circuit with the voltage stored in the capacitor element. The high/low determination circuit determines whether the clock signal frequency is higher or lower than a predetermined reference frequency based on the output signal of the comparator circuit. Therefore, whether the clock signal has a low frequency or a high frequency is determined without using an inverter element whose threshold voltage varies due to variations of the power supply voltage and/or the ambient temperature.

In another embodiment of the frequency determination circuit of the present invention, the current supplied to the capacitor element is kept constant by a constant current circuit according to the reference voltage of the band gap regulator circuit. This maintains the rate at which the capacitor element is charged with the power supply voltage.

In still another embodiment of the present invention, a voltage reducing circuit reduces the reference voltage supplied from the band gap regulator circuit to the constant current circuit to a predetermined voltage. This expands the range of lowest operating voltage of the constant current circuit.

In still another embodiment of the present invention, a current adjusting circuit adjusts the current amount of the constant current circuit. Therefore, any output errors of the constant current circuit due to manufacturing errors are adjusted by the current adjusting circuit.

A data processing unit of the present invention comprises voltage generation means, clock generation means, a data processing circuit, operation control means, and a frequency determination circuit of the present invention. In the first data processing unit of the present invention, the voltage generation means generates a power supply voltage and the clock generation means generates a clock signal. The data processing circuit to which the power supply voltage and the clock signal are input performs a data processing operation. Note that since the power supply voltage and the clock signal are also input to the frequency determination circuit of the present invention, the frequency determination circuit can determine whether the clock signal frequency is higher or lower than the predetermined reference frequency. The operation control means restricts the operation of the data processing circuit according to the determination result. For example, the data processing circuit is stopped when, for example, the clock signal frequency exceeds the reference frequency.

In the second data processing unit of the present invention, a clock signal is not generated internally, but is externally input through a clock input terminal. The reference frequency as described above is set as, for example, a limit predetermined frequency with which the data processing circuit does not malfunction.

In another embodiment of the data processing unit of the present invention, two frequency determination circuits are provided. One frequency determination circuit determines an increase of the clock signal frequency over a predetermined upper limit frequency, and the other determines a decrease below a predetermined lower limit frequency. The operation control means restricts the operation of the data processing circuit when the clock signal frequency increases above the upper limit frequency or when it decreases below the lower limit frequency. Thus, the operation of the data processing circuit is restricted when the clock signal frequency deviates from the normal range.

In another embodiment of the data processing unit of the present invention, one of the two frequency determination circuits determines an increase of the clock signal frequency over the reference frequency based on a low time, and the other makes the determination based on a high time. The operation control means restricts the operation of the data processing circuit when either one of the signal frequencies of the clock signals determined based on the low time and the high time, respectively, exceeds the reference frequency. Thus, the operation of the data processing circuit is restricted when the duty ratio of the clock signal deviates from the normal range.

The various types of means as used in the present invention may each be any means as long as it is provided so as to realize the function thereof, and may be, for example, dedicated hardware, a computer provided with an appropriate function by a program, a function implemented in a computer by an appropriate program, or any combination thereof.

### BRIEF DESCRIPTION OF THE DRAWINGS

Preferred features of the present invention will now be described, by way of example only, with reference to the accompanying drawings, in which:-
FIG. 1 is a circuit diagram illustrating an internal structure of a conventional frequency determination circuit;
FIGS. 2A to 2C are time charts illustrating signal waveforms for various parts of a conventional frequency determination circuit;
FIG. 3 is a block diagram illustrating an internal structure of a frequency determination circuit according to one embodiment of the present invention;
FIG. 4 is a block diagram illustrating an internal structure of a data processing unit;
FIG. 5 is a circuit diagram illustrating an internal structure of a band gap regulator circuit;
FIG. 6 is a circuit diagram illustrating an internal structure of a voltage reducing circuit;
FIG. 7 is a circuit diagram illustrating an internal structure of a constant current circuit;
FIG. 8 is a circuit diagram illustrating an internal structure of a frequency detection circuit;
FIG. 9 is a circuit diagram illustrating an internal structure of a high/low determination circuit; and
FIGS. 10A to 10F are time charts illustrating signal waveforms for various parts of a frequency determination circuit.

### BRIEF DESCRIPTION OF THE INVENTION

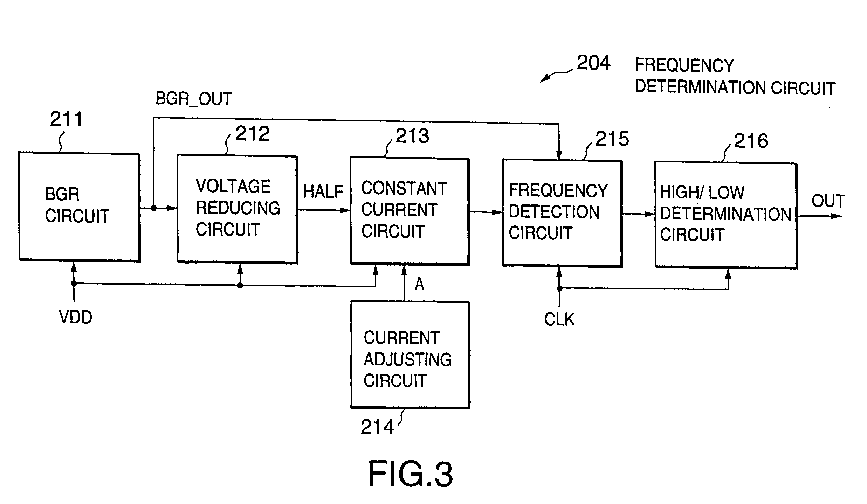

An embodiment of the present invention will now be described with reference to FIGS. 3-10. Note that each component of the present embodiment that is the same as that of the conventional example described above and will be denoted by using the same nomenclature. Therefore, a detailed description thereof will not be provided below.

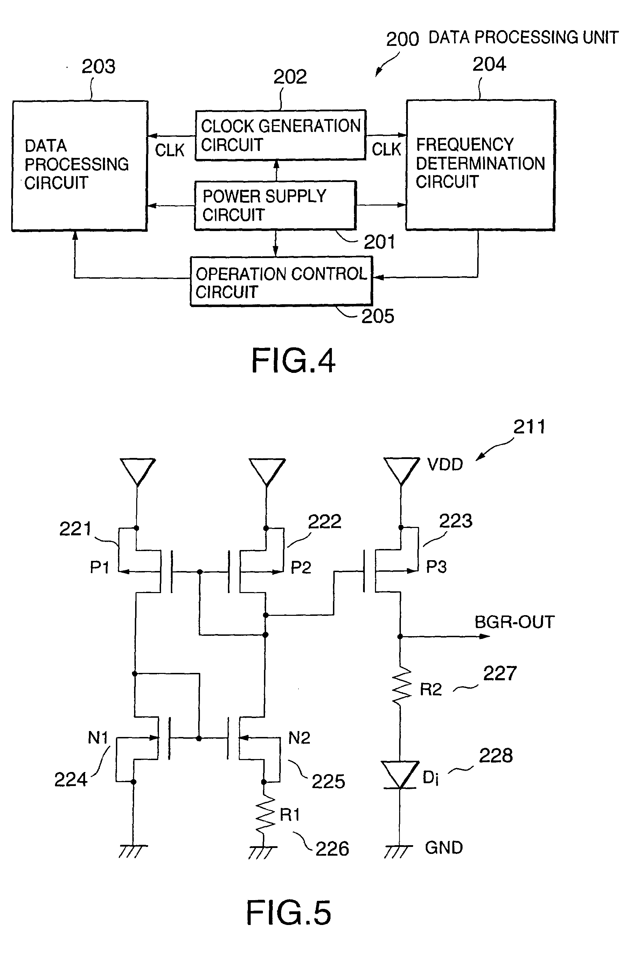

As illustrated in FIG. 4, according to the present invention, a data processing unit 200 comprises a power supply circuit 201 as the voltage generation means, a clock generation circuit 202 as the clock generation means, a data processing circuit 203, a frequency determination circuit 204, an operation control circuit 205 and a predetermined data processing operation is performed by the data processing circuit 203.

The power supply circuit 201 generates a power supply voltage VDD and supplies the voltage to the various circuits 202 to 205 via a feeder terminal. The clock generation circuit 202 comprises a quartz oscillator (not shown) that generates a clock signal CLK whose frequency is defined within a predetermined range. The clock generation circuit 202 supplies the clock signal CLK to the data processing circuit 203 and the frequency determination circuit 204.

The data processing circuit 203 comprises a microcomputer implemented with a predetermined processing program. The voltage VDD and the clock signal CLK are externally input thereto. The data processing circuit 203 performs a predetermined data processing operation when processing data is externally input thereto, and externally outputs processed data resulting from the processing operation.

The frequency determination circuit 204 determines whether the frequency of the clock signal CLK is higher or lower than the reference frequency. The operation control circuit 205 receives the output of the frequency determination circuit 204. When the frequency determination circuit 204 determines that the frequency of the clock signal CLK is higher than the reference frequency, the operation of the data processing circuit 203 is temporarily stopped.

Referring to FIG. 3, the frequency determination circuit 204 comprises a band gap regulator circuit 211, a voltage reducing circuit 212, a constant current circuit 213, a current adjusting circuit 214, a frequency detection circuit 215, and a high/low determination circuit 216.

Referring to FIG. 5, the band gap regulator circuit 211 comprises first to fifth transistor elements 221 to 225, first and second resistance elements 226 and 227, and a diode 228. The band gap regulator circuit 211 produces a constant reference voltage BGR_OUT from the power supply voltage VDD.

More specifically, the band gap regulator circuit 211 comprises a current mirror circuit. The temperature characteristics of the second resistance element 227 and the diode 228, which are connected to the output terminal, are cancelled out, and the dependency on the power supply voltage VDD is low. Since the temperature dependency and the power supply dependency of the band gap regulator circuit 211 are typically minimized when the output voltage is about 1.3V, the band gap regulator circuit 211 is configured to produce the reference voltage BGR_OUT of about 1.3V in the present embodiment.

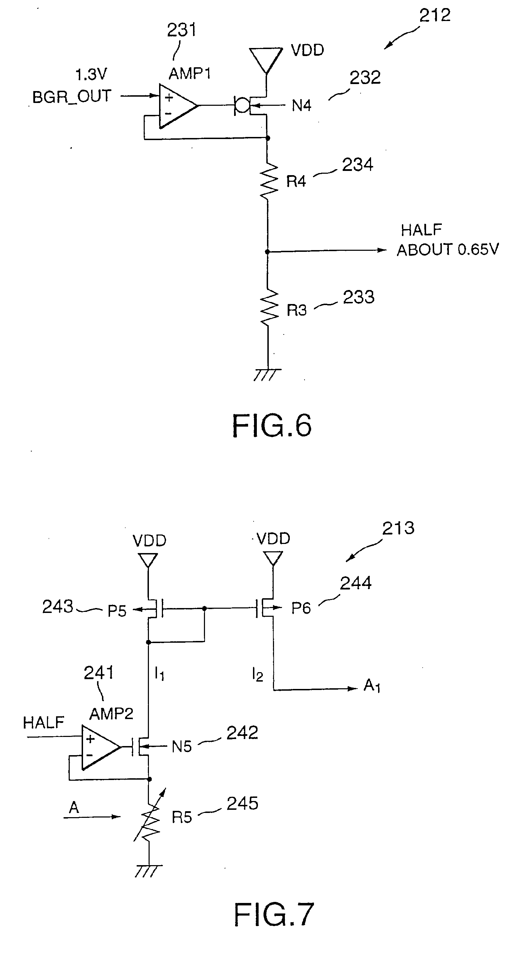

Referring to FIG. 6, the voltage reducing circuit 212 comprises a differential amplifier 231, a transistor element 232, and a pair of resistance elements 223 and 234. The voltage reducing circuit reduces the reference voltage BGR_OUT supplied from the band gap regulator circuit 211 to a predetermined voltage. More specifically, the resistance values R3 and R4 of the resistance elements 233 and 234 are set to be substantially equal to each other. The voltage reducing circuit 212 reduces the reference voltage BGR_OUT, about 1.3V, to a second reference voltage HALF of one half of the value, i.e., about 0.65V.

Referring to FIG. 7, the constant current circuit 213 comprises a differential amplifier 241, first, second and third transistor elements 242 to 244, and a variable resistor 245. The constant current circuit 213 externally outputs the power supply voltage VDD, while keeping constant the current amount thereof at I₂ according to the second reference voltage HALF that is supplied from the voltage reducing circuit 212.

More specifically, the current amount I₁ of the power supply voltage VDD which is conducted through the second transistor element 243 to the variable resistor 245 is equal to I₁ = HALF/R5 (i.e., the second reference voltage HALF and the resistance value R5 of the variable resistor 245). The current amount I₂ of the power supply voltage VDD that conducted by the third transistor element 244 to the frequency detection circuit 215 is constant. The current amount I₂ is constant according to the current amount I₁ at the ratio of the current mirror circuit that is comprised of the second/third transistor elements 243 and 244.

The current adjusting circuit 214 comprises, for example, an EEPROM (Electrically Erasable Programmable Read Only Memory) (not shown). The resistance value R5 of the variable resistor 245 is variable according to the setting data thereof, so as to adjust the power supply voltage VDD output by the constant current circuit 213 to a predetermined current amount.

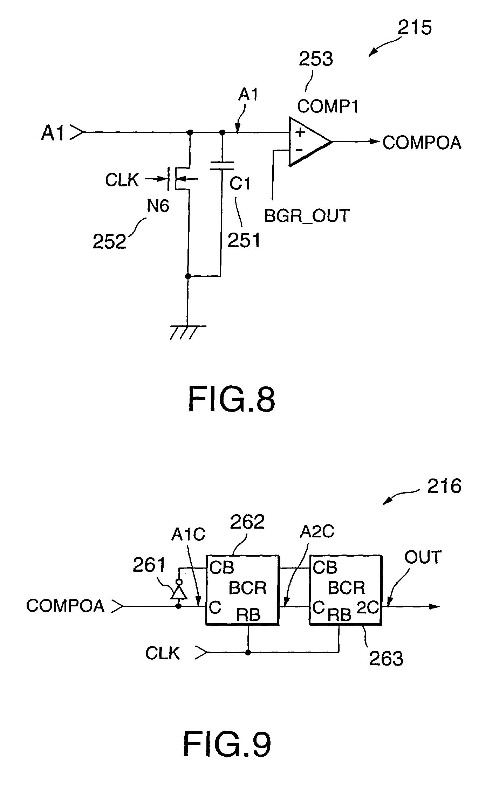

Referring to FIG. 8, the frequency detection circuit 215 comprises a capacitor element 251, a switching transistor 252 and a comparator circuit 253. The capacitor element 251 is charged with the power supply voltage VDD whose current amount is kept constant by the constant current circuit 213.

Note that the switching transistor 252 switches the power supply voltage VDD supplied to the capacitor element 251 according to the clock signal CLK. The capacitor element 251 discharges the charged voltage when the supply of the power supply voltage VDD is turned ON by the switching transistor 252.

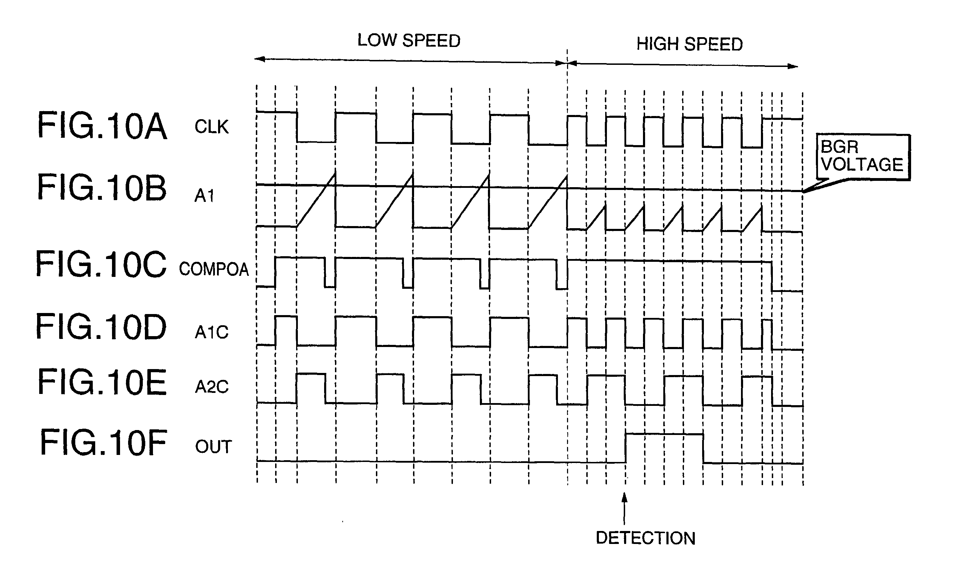

The charging and discharging of the capacitor element 251, which is synchronously performed with the clock signal as described above, is performed according to the predetermined time constant. Therefore, as illustrated in FIG. 10A, if the frequency of the clock signal CLK is lower than the reference frequency, the potential stored in the capacitor element 251 changes. Specifically, the potential stored in the capacitor element 251 changes between a state where the stored potential is lower than the reference voltage BGR_OUT of the band gap regulator circuit 211 and a state where the stored potential is higher than the reference voltage BGR_OUT. This is illustrated in FIG. 10B. If the frequency of the clock signal CLK is higher than the reference frequency, however, the potential stored in the capacitor element 251 is kept in a state where it is lower than the reference voltage BGR_OUT of the band gap regulator circuit 211.

The comparator circuit 253 compares the reference voltage BGR_OUT of the band gap regulator circuit 211 with the voltage stored in the capacitor element 251. As described above, the potential stored in the capacitor element 251 is switched between a state where it changes to be higher and lower than the reference voltage BGR_OUT of the band gap regulator circuit 211 and another state where it is kept to be low, according to the frequency of the clock signal CLK being high or low. Therefore, the binary output COMPOA of the comparator circuit 253 changes in FIG. 10C.

Referring to FIG. 9, the high/low determination circuit 216 comprises an inverter gate 261 and binary counters 262 and 263. The high/low determination circuit 216 determines whether the frequency of the clock signal CLK is higher or lower than the reference frequency. As illustrated in FIGS. 10D to 10F, the high/low determination circuit 216 outputs the determination result OUT to the operation control circuit 205.

Referring to FIG. 3, in the data processing unit 200 of the present invention, the power supply circuit 201 generates the power supply voltage VDD and the clock generation circuit 202 generates the clock signal CLK. The data processing circuit 203 receives the power supply voltage VDD and the clock signal CLK, and the data processing circuit 203 performs a predetermined data processing operation.

The power supply voltage VDD and the clock signal CLK are also input to the frequency determination circuit 204. Therefore, the frequency determination circuit 204 always determines whether the frequency of the clock signal CLK is higher or lower than the reference frequency. The operation control circuit 205 stops the data processing circuit 203 when the clock signal frequency is higher than the reference frequency.

Specifically, in the frequency determination circuit 204, the reference voltage BGR_OUT of about 1.3V is produced by the band gap regulator circuit 211 from the power supply voltage VDD. The reference voltage BGR_OUT is reduced by the voltage reducing circuit 212 to the second reference voltage HALF of about 0.65V.

Then, the constant current circuit 213 supplies the power supply voltage VDD to the frequency detection circuit 215, while keeping constant the current amount thereof according to the second reference voltage HALF. Therefore, in the frequency detection circuit 215, while the capacitor element 251 is charged with the power supply voltage VDD whose current amount is kept constant, the power supply voltage VDD supplied to the capacitor element 251 is turned ON/OFF by the switching transistor 252. The switching transistor 252 is turned ON/OFF by the clock signal CLK.

Thus, if the frequency of the clock signal CLK is lower than the predetermined reference frequency (illustrated in FIG. 10A), the potential stored in the capacitor element 251 changes between a state where it is lower than the reference voltage BGR_OUT of the band gap regulator circuit 211 and a state where it is higher than the reference voltage BGR_OUT, as illustrated in FIG. 10B. However, if the frequency of the clock signal CLK is higher than the reference frequency, the potential stored in the capacitor element 251 is kept in a state where it is lower than the reference voltage BGR_OUT of the band gap regulator circuit 211.

The voltage stored in the capacitor element 251 is compared with the reference voltage BGR_OUT of the band gap regulator circuit 211 by the comparator circuit 253. As illustrated in FIG. 10C, the binary output COMPOA of the comparator circuit 253 is supplied to the high/low determination circuit 216.

As illustrated in FIGS. 10D to 10F, the high/low determination circuit 216 determines whether the frequency of the clock signal CLK is higher or lower than the reference frequency and outputs the determination result OUT to the operation control circuit 205. Then, the operation control circuit 205 stops the data processing circuit 203 when detecting that the frequency of the clock signal CLK is higher than the reference frequency based on the determination result OUT of the high/low determination circuit 216. The operation control circuit 205 resumes the operation of the data processing circuit 203 when, for example, the frequency of the clock signal CLK returns to a value lower than the reference frequency.

In the data processing unit 200, the frequency determination circuit 204 determines whether the frequency of the clock signal CLK is higher than the reference frequency. The operation of the data processing circuit 203 is temporarily stopped according to the determination result. Thus, it is possible to prevent the data processing circuit 203 from malfunctioning due the clock signal having an abnormally high frequency.

Moreover, in the frequency determination circuit 204, the band gap regulator circuit 211 produces the constant reference voltage BGR_OUT from the power supply voltage VDD. The comparator circuit 253 compares the constant reference voltage BGR_OUT with the voltage stored in the capacitor element 251. As described above, the capacitor element 251 is charged with the power supply voltage and discharged in synchronism with the clock signal CLK. Therefore, it is possible to determine whether the frequency of the clock signal CLK is higher or lower than the reference frequency.

Thus, whether the clock signal CLK has a low frequency or a high frequency can be determined without using an inverter element whose threshold voltage varies due to variations of the power supply voltage VDD and/or the ambient temperature. Thus, whether the frequency of the clock signal CLK is high or low can be determined with a high precision, even when the power supply voltage and/or the ambient temperature vary.

Moreover, the amount of current from the power supply voltage VDD supplied to the capacitor element 251 is kept constant by the constant current circuit 213, according to the reference voltage BGR_OUT of the band gap regulator circuit 211. This makes it possible to keep constant the rate at which the capacitor element 251 is charged with the power supply voltage VDD, thereby further improving the determination precision.

Moreover, the current adjusting circuit 214 adjusts the current amount of the constant current circuit 213. Any output errors of the constant current circuit 213 that result from manufacturing errors, or the like, can also be adjusted by the current adjusting circuit 214, thereby further improving the determination precision. Furthermore, the voltage reducing circuit 212 reduces the reference voltage BGR_OUT supplied from the band gap regulator circuit 211 to the constant current circuit 213 to a predetermined voltage. This makes it possible to expand the range of lowest operating voltage of the constant current circuit 213.

The present invention is not limited to the above-described embodiment, and may be variously modified to an extent not departing from the spirit of the invention thereof. For example, the data processing unit 200 determines, with the single frequency determination circuit 204, if there is an increase of the frequency of the clock signal CLK over the predetermined upper limit frequency. If an increase is detected, the operation control circuit 205 temporarily stops the data processing circuit 203, based on that determination.

Alternatively, it is possible to determine a decrease of the frequency of the clock signal CLK below the lower limit frequency by the frequency determination circuit 204 as described above, so as to temporarily stop the data processing circuit 203 by the operation control circuit 205. Moreover, it is possible to determine, with two frequency determination circuits, an increase of the clock signal CLK over the upper limit frequency and a decrease thereof below the lower limit frequency. The operation control circuit 205 temporarily stops the data processing circuit 203 based on both of the determinations.

While an example where an increase of the frequency of the clock signal CLK over the reference frequency is determined based on the low time has been described in the above embodiment, alternatively, it is possible to make the determination based on the high time, for example. Moreover, the clock signal frequency exceeding the reference frequency can be determined independently with two frequency determination circuits based on the low time and the high time, respectively. The operation control circuit 205 stops the data processing circuit 203 when the duty ratio of the clock signal deviates from the normal range.

As described in the above embodiment, the power supply circuit 201 for internally generating the power supply voltage is provided in the data processing unit 200 as the voltage generation means. Alternatively, for example, a voltage input terminal to which a power supply voltage is externally input may be provided as the voltage generation means in the data processing unit 200.

Similarly, as described in the above embodiment, the clock generation circuit 202 for internally generating the clock signal is provided in the data processing unit 200 as the clock generation means. Alternatively, for example, a clock input terminal to which a clock signal is externally input may be provided as the clock generation means in the data processing unit 200.

In the frequency determination circuit of the present invention, the power supply voltage supplied to the capacitor element is turned ON/OFF by the switching transistor according to the clock signal. The capacitor element is charged with the power supply voltage and discharged according to the clock signal. The band gap regulator circuit produces a constant reference voltage from an externally input power supply voltage. The comparator circuit compares the reference voltage of the band gap regulator circuit with the voltage stored in the capacitor element. The high/low determination circuit determines, from the output signal from the comparator circuit, whether the clock signal frequency is higher or lower than the predetermined reference frequency. This makes it possible to determine whether the clock signal has a low frequency or a high frequency with a high precision, even when the power supply voltage and/or the ambient temperature vary.

Moreover, the constant current circuit keeps the current amount of the power supply voltage supplied to the capacitor element constant, according to the reference voltage of the band gap regulator circuit. It is possible to keep constant the rate at which the capacitor element is charged with the power supply voltage, thereby improving the precision of the determination whether the clock signal has a low frequency or a high frequency.

Moreover, the voltage reducing circuit reduces the reference voltage supplied from the band gap regulator circuit to the constant current circuit to a predetermined voltage, making it is possible to expand the range of lowest operating voltage of the constant current circuit.

Moreover, the current adjusting circuit adjusts the current amount of the constant current circuit, making it possible to adjust output errors of the constant current circuit due to manufacturing errors, or the like, by the current adjusting circuit. This further improves the precision of the determination whether the clock signal has a low frequency or a high frequency.

In the first data processing unit of the present invention, the voltage generation means generates the power supply voltage and the clock generation means generates the clock signal. The data processing circuit to which the power supply voltage and the clock signal are input performs a data processing operation. The frequency determination circuit determines whether the clock signal frequency is higher or lower than the reference frequency. The operation control means restricts the operation of the data processing circuit according to the determination result. This makes if possible to, for example, to stop the data processing circuit when the clock signal frequency becomes abnormal.

In the second data processing unit of the present invention, the voltage generation means generates the power supply voltage and the clock signal is externally input through the clock input terminal. The data processing circuit, to which the power supply voltage and the clock signal are externally input, performs a data processing operation. The frequency determination circuit determines whether the clock signal frequency is higher or lower than the reference frequency. The operation control means restricts the operation of the data processing circuit according to the determination result. This makes it is possible to, for example, stop the data processing circuit when the clock signal frequency becomes abnormal.

In another embodiment of the data processing unit of the present invention, two frequency determination circuits are provided. One frequency determination circuit determines if there is an increase of the clock signal frequency over a predetermined upper limit frequency, and the other frequency determination circuit determines if there is a decrease of the clock signal frequency over a predetermined upper limit frequency. The operation control means restricts the operation of the data processing circuit both when the clock signal frequency increases above the upper limit frequency and when the clock signal frequency decreases below the lower limit frequency. This makes it is possible to, for example, stop the data processing circuit when the clock signal frequency deviates from the normal range.

One of the two frequency determination circuits determines if the clock signal frequency exceeds the reference frequency based on the low time, and the frequency determination circuit makes the determination based on the high time. The operation control means restricts the operation of the data processing circuit when either one of the frequencies of the clock signals is determined to exceed the reference frequency, based on the low time and the high time. This makes it is possible to, for example, stop the data processing circuit when the duty ratio of the clock signal deviates from the normal range.

The present invention is not limited to the above embodiments, and it is contemplated that numerous modifications may be made without departing from the scope of the invention. The frequency determination circuit, as described above with reference to the figures, is merely an exemplary embodiment of the invention, and the scope of the invention is not limited to these particular embodiments. Accordingly, other structural configurations may be used, without departing from the scope of the invention as defined in the following claims.

Each feature disclosed in this specification (which term includes the claims) and/or shown in the drawings may be incorporated in the invention independently of other disclosed and/or illustrated features.

The text of the abstract filed herewith is repeated here as part of the specification.

A frequency determination circuit determines, with a high precision, whether the frequency of a clock signal is higher or lower than a reference frequency. A capacitor element is charged/discharged with a power supply voltage that is cycled by a switching transistor according to a clock signal. A comparator circuit compares a constant reference voltage produced by a band-gap regulator circuit from the power supply voltage with a voltage stored in the capacitor element. A high/low determination circuit determines, from the output signal of the comparator circuit, whether the clock signal frequency is higher or lower than a predetermined reference frequency. This makes it possible to determine whether the clock signal has a low frequency or a high frequency with precision.

The present application is based on Japanese Patent Application No. 245837/2000, which is incorporated herein by reference.

## Claims

1. A frequency determination circuit comprising:
band-gap regulation means for producing a constant reference voltage from a power supply voltage;
capacitance means for charging with said power supply voltage and discharging in response to a clock signal;
comparison means for comparing a voltage stored in said capacitance means with said constant reference voltage of said band-gap regulation means; and,
high/low determination means for determining whether the frequency of said clock cycle is higher or lower than a predetermined reference frequency, based on an output signal of said comparison means, and outputting a determination result.

2. The frequency determination circuit as claimed in claim 1, further comprising a switching means connected parallel to said capacitance means between an input terminal of said comparison means and a source voltage, effectuating said charging and discharging of said capacitance means in response to said clock signal.

3. The frequency determination circuit as claimed in claim 1, further comprising constant-current means for supplying said power supply voltage to said capacitance means while maintaining a substantially constant current to said capacitance means.

4. The frequency determination circuit as claimed in claim 3, wherein said substantially constant current is determined in response to said constant reference voltage of said band-gap regulation means.

5. The frequency determination circuit as claimed in claim 4, further comprising a voltage-reducing means for reducing said constant reference voltage, supplied from said band-gap regulation means to said constant-current means, to a predetermined voltage.

6. The frequency determination circuit as claimed in claim 5, further comprising a current adjusting means for adjusting said substantially constant current of said constant current means.

7. A data processing unit comprising:
a voltage generation means for supplying a power supply voltage;
a clock generation means supplying a clock signal;
a first frequency determination means, said frequency determination means comprising:
band-gap regulation means for producing a constant reference voltage from said power supply voltage;
capacitance means for charging with said power supply voltage and discharging in response to said clock signal;
comparison means comparing a voltage stored in said capacitance means with said constant reference voltage of said constant voltage means;
high/low determination means for determining whether the frequency of said clock signal is higher or lower than a predetermined reference frequency, based on an output signal of said comparison means, and outputting a determination result;
a data processing means, to which said clock signal and said power supply voltage are input, that performs a data processing operation; and,
an operation control means for restricting said data processing means, in response to said determination result.

8. The data processing unit as claimed in claim 7, wherein said first frequency determination means further comprises switching means connected parallel to said capacitance means between an input terminal of said comparison means and a source voltage, effectuating said charging and discharging of said capacitance means in response to said clock signal.

9. The data processing unit as claimed in claim 7, wherein said first frequency determination means further comprises a constant-current means supplying said power supply voltage to said capacitor while maintaining a substantially constant current to said capacitance means.

10. The data processing unit as claimed in claim 9, wherein said substantially constant current is determined in response to said constant reference voltage of said band-gap regulation means.

11. The data processing unit as claimed in claim 10, wherein said first frequency determination means further comprises a voltage-reducing means for reducing said constant reference voltage, supplied from said band-gap regulation means to said constant-current circuit, to a predetermined voltage.

12. The data processing unit as claimed in claim 11, wherein said first frequency determination means further comprises a current-adjusting means for adjusting said substantially constant current of said constant-current means.

13. The data processing unit claimed in claim 7, wherein:
said first frequency determination means determines an increase of the frequency of said clock signal over a predetermined upper limit frequency;
said data processing unit further comprises a second frequency determination means that determines a decrease of the frequency of said clock signal below a predetermined lower limit frequency; and,
said operation control means restricts said data processing means when the frequency of said clock signal increases above the upper limit frequency or when the frequency of said clock signal decreases below the lower limit frequency.

14. The data processing unit claimed in claim 7, wherein:
said first frequency determination means determines whether the frequency of said clock signal is higher or lower than said predetermined reference frequency based on a low time;
said data processing unit further comprises a second frequency determination means that determines whether the frequency of said clock singal is higher or lower than said predetermined reference frequency based on a high time; and,
said operation control means restricts said data processing means when it is determined that the frequency of said clock signal exceeds said predetermined reference frequency from either one of the low time and the high time.
